# FASCICULE DE BREVET EUROPEEN

(11) **EP 4 163 650 B1**
(45) Date de publication et mention de la délivrance du brevet: **14.02.2024**
(21) Numéro de dépôt: 22199905.5
(22) Date de dépôt: 05.10.2022
(51) Int. Cl.: G01R 31/00, G01R 31/52

(54) **SYSTÈME DE DIAGNOSTIC DE L ÉTAT D'UN CIRCUIT D ALIMENTATION BASSE TENSION D'UN VÉHICULE FERROVIAIRE ; VÉHICULE FERROVIAIRE ET PROCÉDÉ DE DIAGNOSTIC ASSOCIÉS**
SYSTEM ZUR DIAGNOSE DES ZUSTANDS EINER NIEDERSPANNUNGSVERSORGUNGSSCHALTUNG EINES SCHIENENFAHRZEUGS; ENTSPRECHENDES SCHIENENFAHRZEUG UND DIAGNOSEVERFAHREN.
SYSTEM FOR DIAGNOSING THE STATE OF A LOW-VOLTAGE POWER SUPPLY CIRCUIT OF A RAILWAY VEHICLE; ASSOCIATED RAILWAY VEHICLE AND DIAGNOSTIC METHOD.

(30) Priorité: 06.10.2021 FR 2110581
(43) Date de publication de la demande: 12.04.2023
(73) Titulaire: ALSTOM Holdings, 93400 Saint-Ouen-sur-Seine (FR)
(72) Inventeur: BOLLENGIER, Christophe, 68780 SENTHEIM (FR)
(74) Mandataire: Lavoix

(56) Documents cités:
- EP-A1- 1 085 634
- EP-A1- 2 872 359
- WO-A1-2020/140716
- CN-A- 108 674 440

## Description

La présente invention a pour domaine celui des systèmes et des procédés de diagnostic de l'état d'un circuit électrique basse tension continue équipant un véhicule ferroviaire. Le document EP2872359 A1 divulgue un système de gestion et de distribution d'énergie pour un véhicule sur rail, comprenant : - une pluralité de transformateurs de traction électroniques de puissance pour se coupler à un caténaire pour recevoir une puissance haute tension; - un bus commun qui est connecté pour fournir une énergie électrique basse tension à une ou plusieurs charges; et - une unité de commande apte à activer et de désactiver les transformateurs de traction électroniques de puissance en fonction de la puissance totale requise par les charges.

Un type de circuit électrique basse tension continue comporte : une ligne de potentiel de référence de masse (ou ligne de référence dans ce qui suit), connecté à un potentiel de référence associé à une masse mécanique du véhicule ferroviaire (telle que la caisse du véhicule ferroviaire) ; une ligne de potentiel MOINS batterie (ou ligne MOINS dans ce qui suit), connectée à une borne négative d'une source de tension ; et une ligne de potentiel PLUS batterie (ou ligne PLUS dans ce qui suit), connectée à une borne positive de la source de tension.

Les lignes de référence, MOINS et PLUS circulent parallèlement les unes aux autres, à travers des différentes voitures attelées les unes à la suite des autres pour former le véhicule ferroviaire.

Un circuit électrique basse tension continue (par exemple +24V ou +110V) permet d'alimenter des équipements auxiliaires placés dans les différentes voitures, tels qu'un système d'ouverture de portes, un système d'éclairage, etc.

Pour ce type particulier de circuit électrique basse tension continue, dans lequel la ligne MOINS n'est pas portée au potentiel de référence, la détection de la survenue d'un court-circuit entre soit la ligne MOINS et la ligne de référence, soit la ligne PLUS et la ligne de référence, ainsi que la localisation de ce court-circuit dans l'une ou l'autre des voitures composant le véhicule ferroviaire, est un problème qui n'a pas encore trouvé de solution satisfaisante.

Jusqu'à présent, estimant qu'un court-circuit entre la ligne MOINS et la ligne de référence n'a pas de conséquence désastreuse (une différence de potentiel étant encore appliquée aux équipements auxiliaires), un tel court-circuit n'est pas pris en compte. Le véhicule ferroviaire peut continuer à être exploité pendant plusieurs semaines malgré cette anomalie. Cependant, cette situation présente le risque qu'en cas de survenue d'un autre court-circuit, celui-ci entre la ligne PLUS et la ligne de référence, le véhicule soit en avarie majeure, conduisant à son immobilisation immédiate sur la voie et à un blocage de la circulation de l'ensemble des trains.

La survenue d'un court-circuit entre la ligne PLUS et la ligne de référence est pris en compte comme un dysfonctionnement nécessitant une opération de maintenance. Pour localiser ce court-circuit, les différentes voitures doivent d'abord être dételées les unes des autres, puis, pour chaque voiture, la ligne PLUS est testée par un opérateur de maintenance pour déterminer si c'est bien dans cette voiture que le court-circuit se situe. Une fois le court-circuit localisé, une réparation adaptée est entreprise.

Il s'agit donc d'un processus lourd à mettre en oeuvre puisqu'il implique que le véhicule soit indisponible pendant un temps relativement long. De plus, ce processus n'est mis en oeuvre que pour un type particulier de court-circuit.

Le but de la présente invention est par conséquent de résoudre ce problème.

Pour cela, l'invention a pour objet un système de diagnostic d'un état d'un circuit électrique basse tension continue d'un véhicule ferroviaire, le véhicule ferroviaire comportant une pluralité de voitures attelées les unes aux autres, le circuit électrique basse tension continue comportant, circulant les unes parallèlement aux autres, le long de la pluralité voitures : une ligne de potentiel de référence, portée à un potentiel de référence ; une ligne de potentiel PLUS batterie, connectée à une borne positive d'une source de tension électrique ; et, une ligne de potentiel MOINS batterie, connectée à une borne négative de la source de tension électrique, le système de diagnostic étant caractérisé en ce que la ligne de potentiel PLUS batterie est constituée de la connexion en série d'une pluralité de segments de ligne de potentiel PLUS batterie, la pluralité de segments de ligne de potentiel PLUS batterie comportant au moins un segment de ligne de potentiel PLUS batterie par voiture, deux segments de ligne de potentiel PLUS batterie successifs étant connectés par un contacteur de ligne de potentiel PLUS batterie pouvant être commandé en position ouverte ou en position fermée, en ce que la ligne de potentiel MOINS batterie est constituée de la connexion en série d'une pluralité de segments de ligne de potentiel MOINS batterie, la pluralité de segments de ligne de potentiel MOINS batterie comportant au moins un segment de ligne de potentiel MOINS batterie par voiture, deux segments de ligne de potentiel MOINS batterie successifs étant connectés par un contacteur de ligne de potentiel MOINS batterie pouvant être commandé en position ouverte ou en position fermée, le premier segment de ligne de potentiel PLUS batterie étant connecté à la borne positive de la source de tension électrique et le premier segment de ligne de potentiel MOINS batterie étant connecté à la borne négative de la source de tension électrique, et en ce que le système de diagnostic comporte un moyen de commande et un circuit de mesure, le circuit de mesure comportant au moins une maille de mesure, ladite au moins une maille de mesure intégrant un moyen de mesure du courant circulant le long de ladite au moins une maille de mesure, un noeud d'extrémité de ladite au moins une maille de mesure étant relié électriquement à la ligne de potentiel de référence et l'autre noeud d'extrémité de ladite au moins une maille de mesure pouvant être connecté, par un premier interrupteur commandé, au premier segment de ligne de potentiel PLUS batterie et, par un second interrupteur commandé, au premier segment de ligne de potentiel MOINS batterie, le moyen de commande étant propre à basculer en fermeture le premier interrupteur pour relier ladite au moins une maille de mesure à la ligne de potentiel PLUS batterie, et, en cas de détection d'un court-circuit, à basculer séquentiellement en ouverture les contacteurs de ligne de potentiel MOINS batterie pour localiser le court-circuit le long de la ligne de potentiel MOINS batterie, et le moyen de commande étant propre à basculer en fermeture le second interrupteur pour relier ladite au moins une maille de mesure à la ligne de potentiel MOINS batterie, et, en cas de détection d'un court-circuit, à basculer séquentiellement en ouverture les contacteurs de ligne de potentiel PLUS batterie pour localiser le court-circuit le long de la ligne de potentiel PLUS batterie.

Suivant les modes particuliers de réalisation, le système de diagnostic comporte une ou plusieurs des caractéristiques suivantes, prises isolément ou suivant toutes les combinaisons techniquement possibles :
- le circuit de mesure comporte : une première maille de mesure intégrant le premier interrupteur commandé et des premiers moyens de mesure du courant circulant dans la première maille de mesure ; et, une seconde maille de mesure intégrant le second interrupteur commandé et des seconds moyens de mesure du courant circulant dans la seconde maille de mesure ;
- les moyens de mesure du courant circulant dans la première maille de mesure, respectivement circulant dans la seconde maille de mesure, comportent une première résistance le long de la première maille de mesure, respectivement une seconde résistance le long de la première maille de mesure, et un premier capteur de courant propre à mesure un courant circulant à travers la première résistance, respectivement un second capteur de courant le long de la seconde maille de mesure, les premier et seconds capteurs de courant étant de préférence du type par induction ;
- le moyen de mesure du courant circulant le long de ladite au moins une maille est propre à transmettre une mesure d'intensité au moyen de commande, et le moyen de commande est propre à comparer la mesure d'intensité reçue avec un seuil prédéterminé, un court-circuit étant détecté lorsque la mesure d'intensité reçue est supérieure au seuil prédéterminé ;
- le système comporte en outre un circuit de test d'un état de fonctionnement du circuit de mesure, le circuit de test étant commandé par le moyen de commande pour créer un court-circuit artificiel le long du circuit électrique basse tension continue de manière à pouvoir vérifier que le circuit de mesure est capable de détecter ledit court-circuit artificiel ;
- le moyen de commande est programmé pour que la séquence d'ouverture des contacteurs de la ligne de potentiel MOINS batterie, respectivement de la ligne de potentiel PLUS batterie, afin de localiser un court-circuit consiste à remonter la ligne de potentiel MOINS batterie, respectivement la ligne de potentiel PLUS batterie, depuis une extrémité aval, située à l'écart de la source de tension électrique, vers une extrémité amont, à proximité de la source de tension électrique, en ouvrant un contacteur courant et en déterminant si le circuit de mesure détecte encore le court-circuit, dans l'affirmative, le moyen de commande considère un contacteur suivant le contacteur courant et, dans la négative, le moyen de commande considère que le court-circuit est localisé entre le contacteur courant et un contacteur précédent le contacteur courant.

L'invention concerne également un véhicule ferroviaire comportant un circuit électrique basse tension continue, le véhicule ferroviaire comportant une pluralité de voitures attelées les unes aux autres, le circuit électrique basse tension continue comportant, circulant les unes parallèlement aux autres, le long de la pluralité voitures : une ligne de potentiel de référence, portée à un potentiel de référence ; une ligne de potentiel PLUS batterie, connectée à une borne positive d'une source de tension électrique ; et, une ligne de potentiel MOINS batterie, connectée à une borne négative de la source de tension électrique, le véhicule ferroviaire étant caractérisé en ce qu'il comporte un système de diagnostic tel que défini ci-dessus.

L'invention concerne encore un procédé de diagnostic d'un état d'un circuit électrique basse tension d'un véhicule ferroviaire, le véhicule ferroviaire comportant une pluralité de voitures attelées les unes aux autres, le circuit électrique basse tension continue comportant, circulant les unes parallèlement aux autres, le long de la pluralité voitures : une ligne de potentiel de référence, portée à un potentiel de référence ; une ligne de potentiel PLUS batterie, connectée à une borne positive d'une source de tension électrique ; et, une ligne de potentiel MOINS batterie, connectée à une borne négative de la source de tension électrique, le procédé de diagnostic étant caractérisé en ce qu'il consiste, le véhicule ferroviaire étant équipé d'un système de diagnostic tel que défini ci-dessus, à basculer en fermeture le premier interrupteur pour relier la ligne de potentiel PLUS batterie à la ligne de référence via une première résistance et, en cas de détection d'un court-circuit, à basculer séquentiellement en ouverture les contacteurs de ligne de potentiel MOINS batterie pour localiser le court-circuit le long de la ligne de potentiel MOINS batterie, et à basculer en fermeture le second interrupteur pour relier la ligne de potentiel MOINS batterie à la ligne de potentiel de référence via une seconde résistance, et, en cas de détection d'un court-circuit, à basculer séquentiellement en ouverture les contacteurs de ligne de potentiel PLUS batterie pour localiser le court-circuit le long de la ligne de potentiel PLUS batterie.

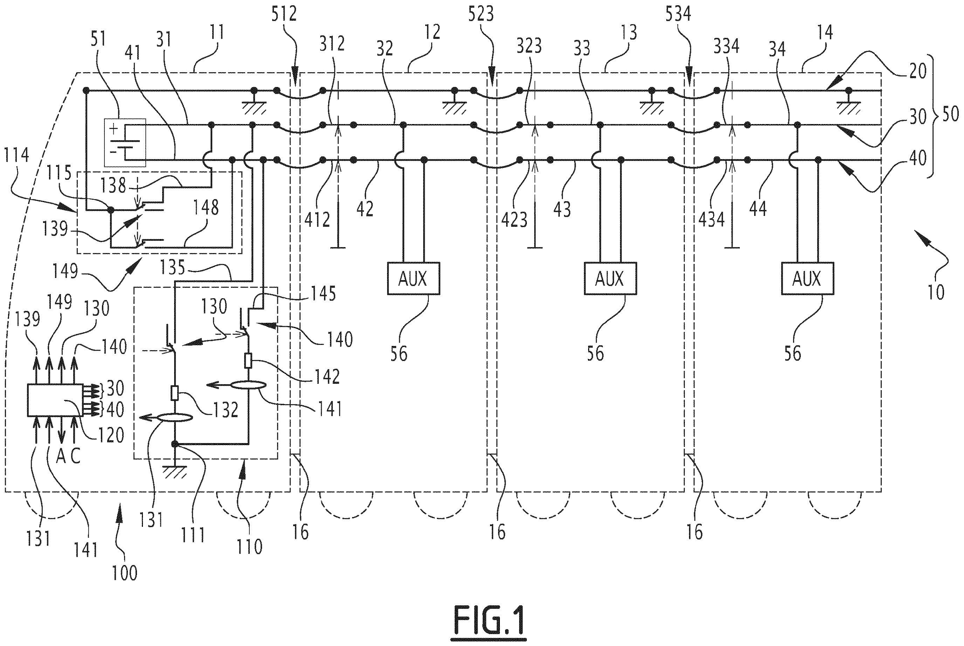

L'invention et ses avantages seront mieux compris à la lecture de la description détaillée qui va suivre d'un mode de réalisation particulier, donnée uniquement à titre d'exemple non limitatif, cette description étant faite en se référant au dessin annexé sur lequel [Fig 1] la figure 1 est une représentation électrique schématique du système de diagnostic selon l'invention.

La figure 1 représente un véhicule ferroviaire 10, tel qu'un train, un tramway, un métro, ou l'équivalent.

Le véhicule 10 est composé d'une pluralité de voitures attelées mécaniquement les unes aux autres. Dans le mode de réalisation de la figure 1, le véhicule 10 comporte quatre voitures : une voiture de tête 11, telle qu'une locomotive, et trois voitures 12, 13, 14, telles que des voitures passagers. Bien évidemment, le nombre de voitures peut varier en fonction de la composition du véhicule. Sur la figure, les moyens d'attelage mécanique sont référencés de manière générale par le chiffre 16.

Le véhicule 10 est équipé d'un circuit électrique basse tension continue 50 et d'une source de tension électrique 51 propre à délivrer une tension basse continue, par exemple de 24V ou de 110V).

Le circuit 50 comporte une ligne de potentiel de référence de masse (ou ligne de référence) 20, une ligne de potentiel MOINS batterie (ou ligne MOINS) 40, et une ligne de potentiel PLUS batterie (ou ligne PLUS) 30.

Ces trois lignes circulent parallèlement les unes aux autres, d'une voiture à l'autre, le long de l'intégralité du véhicule 10.

La ligne de référence 20 est portée à un potentiel de référence. Elle est par exemple reliée à une masse mécanique du véhicule 10.

La ligne MOINS 40 est connectée à une borne négative de la source 51.

La ligne PLUS 30 est connectée à une borne positive de la source 51.

La source de tension électrique 51 peut être une batterie, ou encore un étage de sortie d'un convertisseur permettant d'abaisser la tension d'un courant haute tension collecté par le véhicule 10, par exemple sur une ligne aérienne de contact, ou encore un chargeur batterie.

Le circuit électrique basse tension 50 permet d'alimenter en courant électrique différents équipements auxiliaires, par exemple situés dans les voitures passagers 12, 13 et 14. Ils sont référencés de manière générale par le chiffre 56 sur la figure 1. Ces équipements auxiliaires sont typiquement des systèmes d'éclairage, d'actionnement des portes, des afficheurs, etc. Un équipement auxiliaire est connecté entre la ligne MOINS 40 et la ligne PLUS 30.

Les différentes lignes composant le circuit 50 sont respectivement constituées par la mise en série d'une pluralité de segments. Chaque segment est associé à une voiture. Par exemple, la ligne PLUS 30 est constituée de la mise en série des segments de ligne PLUS, 31, 32, 33 et 34. De la même manière, la ligne MOINS 40 est constituée de la mise en série des segments de ligne MOINS 41, 42, 43 et 44.

Les différents segments d'une ligne sont reliés en série, lors de l'attelage du véhicule, au moyen de câbles de connexion électrique adaptés 10. Ainsi, entre la première voiture 11 et la seconde voiture 12, un ensemble de câbles 512 établit la continuité électrique entre les segments des différentes lignes du circuit 50. De même, entre la seconde voiture 12 et la troisième voiture 13, un ensemble de câbles 523 établit la continuité électrique entre les segments des différentes lignes du circuit 50. Enfin, entre la troisième voiture 13 et la quatrième voiture 14, un ensemble de câbles 534 établit la continuité électrique entre les segments des différentes lignes du circuit 50.

Selon l'invention, le véhicule 10 est équipé d'un système de diagnostic 100 permettant de détecter la survenue d'un court-circuit soit entre la ligne MOINS 40 et la masse (c'est-à-dire la ligne de référence 20), soit entre la ligne PLUS 30 et la masse (c'est-à-dire la ligne de référence 20). Le système de diagnostic 100 permet aussi, avantageusement, de localiser automatiquement où se situe le court-circuit détecté, c'est-à-dire d'identifier le segment de la ligne MOINS ou de la ligne PLUS concerné, c'est-à-dire encore la voiture concernée.

Pour cela, le système de diagnostic 100 comporte, pour la ligne PLUS 30, un contacteur commandé interposé entre deux segments de ligne PLUS successifs. Ainsi, un contacteur 312 est interposé entre le premier segment de ligne PLUS 31 et le second segment de ligne PLUS 32, un contacteur 323 est interposé entre le second segment de ligne PLUS 32 et le troisième segment de ligne PLUS 33, et un contacteur 324 est interposé entre le troisième segment de ligne PLUS 33 et le quatrième segment de ligne PLUS 34.

De manière similaire, des contacteurs commandés 412, 423 et 434 sont respectivement interposés entre les segments de ligne MOINS 41 et 42, 42 et 43, 43 et 44.

De préférence, un contacteur commandé entre un segment d'une voiture amont (par rapport à la source 51) et un segment d'une voiture aval est situé en entrée du segment de la voiture aval, juste en aval du câble électrique reliant la voiture amont et la voiture aval.

Le système de diagnostic 100 comporte également un circuit de mesure 110.

Le circuit de mesure 110 comporte une première maille de mesure 135, connectée entre le premier segment de ligne PLUS 31 et un point 111 porté au potentiel de référence. Le premier circuit de mesure 110 comporte une seconde maille de mesure 145 connectée entre le premier segment de ligne MOINS 41 et le point 111.

La première maille de mesure de ligne PLUS 135 intègre par exemple un premier interrupteur commandé 130 et des premiers moyens de mesure du courant circulant dans la première maille 135. Ces premiers moyens de mesure sont constitués par exemple d'une première résistance 132, disposée le long de la première maille 135 et d'un premier capteur de courant 131, de préférence du type par induction, propre à mesurer l'intensité du courant circulant dans la première maille 135.

De manière similaire, la seconde maille de mesure de ligne MOINS 145 intègre par exemple un second interrupteur commandé 140 et des seconds moyens de mesure du courant circulant dans la seconde maille 145. Ces seconds moyens de mesure sont constitués par exemple d'une seconde résistance 142, disposée le long de la seconde maille et d'un second capteur de courant 141, de préférence du type par induction, propre à mesurer l'intensité du courant circulant dans la seconde maille 145.

Le premier interrupteur commandé 130, respectivement le deuxième interrupteur commandé 140, est propre à être commandé en ouverture de manière à isoler les premiers moyens de mesure, respectivement les seconds moyens de mesure, de la ligne de référence, ou en fermeture de manière à connecter les premiers moyens de mesure entre la ligne PLUS et le point 111 (porté au potentiel de référence), respectivement les seconds moyens de mesure entre la ligne MOINS et le point 111 (porté au potentiel de référence).

De manière particulièrement avantageuse, le système de diagnostic 110 comporte, en outre, un circuit de test 114 permettant de vérifier le bon fonctionnement du circuit de mesure 110.

Le circuit de test 114 comporte par exemple une première maille de test 138 entre par exemple le premier segment 31 de la ligne PLUS 30 et un point 115 relié électriquement à la ligne de référence 20, ainsi qu'une seconde maille de test 148 entre par exemple le premier segment 41 de la ligne MOINS 40 et le point 115.

La première maille de test 138 intègre un troisième interrupteur commandé 139. Dans l'état ouvert de l'interrupteur 139, la ligne PLUS 30 est isolée de la ligne de référence 20 (pour un fonctionnement nominal du circuit basse tension 50, c'est-à-dire sans court-circuit préexistant). Dans l'état fermé de l'interrupteur 139, un court-circuit entre la ligne PLUS 30 et la ligne de référence 20 est artificiellement crée de manière à vérifier que le circuit de mesure 110 est capable de le détecter, indiquant ainsi son bon état de fonctionnement.

De manière similaire, la seconde maille de test 148 intègre un quatrième interrupteur commandé 149. Dans l'état ouvert de l'interrupteur 149, la ligne MOINS 40 est isolée de la ligne de référence 20 (pour un fonctionnement nominal du circuit basse tension 50, c'est-à-dire sans court-circuit préexistant). Dans l'état fermé de l'interrupteur 149, un court-circuit entre la ligne MOINS 40 et la ligne de référence 20 est artificiellement crée de manière à vérifier que le circuit de mesure 110 est capable de le détecter, indiquant ainsi son bon état de fonctionnement.

Enfin, le système de diagnostic 100 comporte un moyen de commande 120 des différents interrupteurs et contacteurs du système 100. Il s'agit par exemple d'un composant électronique convenablement programmé.

Le moyen de commande 120 est propre à prendre en entrée les signaux de mesures délivrés par les capteurs de courant 131 et 141 du circuit de mesure 110.

Le moyen de commande 120 est propre à émettre en sortie des signaux de commande des différents moyens d'interruption, aussi bien les contacteurs 312, 323, 334 le long de la ligne PLUS 30, les contacteurs 412, 423, 434 le long de la ligne MOINS 40, les premier et second interrupteurs 130 et 140 du circuit de mesure 110, et éventuellement les troisième et quatrième interrupteurs 139, 149 du circuit de test 114.

Le moyen de commande 120 est propre à recevoir un signal d'activation C sur une entrée.

En cas de détection d'un court-circuit, le moyen de commande 120 est propre à émettre un signal d'alarme A sur une sortie. Le signal d'alarme indique par exemple la nature du court-circuit (entre la ligne PLUS 30 et la ligne de référence ou entre la ligne MOINS 40 et la ligne de référence), ainsi avantageusement que l'identifiant de la voiture concernée.

Les signaux C et A sont par exemple échangés avec une interface homme-machine (non représentée sur la figure), soit présente à demeure dans la cabine du conducteur du véhicule ferroviaire 10, soit portable et utilisée par un opérateur de maintenance.

Le fonctionnement du système de diagnostic 100 va maintenant être présenté.

Lors de la réception d'un signal d'activation C par le moyen 120, le système 100 est mis en oeuvre de la manière suivante.

Le moyen de commande 120 émet d'abord un signal de commande conduisant à la fermeture du premier interrupteur 130. En fermant le premier interrupteur 130, la borne positive de la source 51 est mise artificiellement au potentiel de référence via la première résistance 132. Le courant circulant à travers la première résistance 132 est alors mesuré par le premier capteur 131. Le signal de mesure est transmis au moyen 120. S'il y a effectivement un problème affectant la ligne MOINS 40 du type court-circuit avec la ligne de référence 20, un courant circule entre la ligne MOINS et la ligne de référence et entre la ligne de référence et la ligne PLUS 30, c'est-à-dire à travers la première maille 135. Le moyen 120 compare par conséquent le niveau du courant dans la première maille 135 à un premier seuil de référence. Si le courant mesuré est en dessous de ce seuil, il n'y a aucun court-circuit. Dans ce cas contraire, un court-circuit (plus ou moins impédant) entre la ligne MOINS 40 et la ligne de référence 20 est détecté.

S'il n'y a pas de court-circuit, le moyen 120 émet un signal de commande conduisant à la réouverture du premier interrupteur 130. Il émet ensuite un signal de commande conduisant à la fermeture du second interrupteur 140 afin de relier la ligne MOINS 40 et la ligne de référence 20. En fermant le second interrupteur 140, la borne négative de la source 51 est mise artificiellement au potentiel de référence via la seconde résistance 142. Le courant circulant à travers la seconde résistance 142 est alors mesuré par le second capteur 141. Le signal de mesure est transmis au moyen de commande 120. S'il y un problème affectant la ligne PLUS du type court-circuit avec la ligne de référence 20, un courant circule entre la ligne PLUS et la ligne de référence et entre la ligne de référence et la ligne MOINS, c'est-à-dire à travers la seconde maille 145. Le moyen 120 compare le niveau du courant dans la maille 145 à un second seuil de référence. Si le courant mesuré est en dessous de ce seuil, il n'y a aucun court-circuit. Dans le cas contraire, un court-circuit (plus ou moins impédant) entre la ligne PLUS et la ligne de référence est détecté.

S'il n'y a pas de court-circuit, le moyen de commande 120 émet un signal de commande conduisant à la réouverture du second interrupteur 130.

En revanche, si un court-circuit est détecté, le moyen de commande 120 met avantageusement en oeuvre les étapes suivantes pour déterminer la localisation de ce court-circuit.

Dans le cas de la détection d'un court-circuit entre la ligne PLUS 30 et la ligne de référence 20, le moyen de commande 120 commande séquentiellement les contacteurs commandés de la ligne PLUS 30 pour déterminer quel segment de ligne PLUS est en court-circuit.

Par exemple, le moyen 120 commande en ouverture le contacteur 334 le plus éloigné de la source 51.

Si le second capteur 141 ne détecte plus le court-circuit, cela signifie que le court-circuit initialement détecté est situé le long du segment de ligne PLUS 34 de la voiture 14. Le procédé de localisation s'interrompt.

Au contraire, si le capteur 141 détecte encore l'existence d'un court-circuit, cela signifie que ce court-circuit n'est pas le long du segment de ligne PLUS 34 de la voiture 14, mais en amont de celui-ci.

Dans ce cas, le moyen 120 commande en ouverture le contacteur antépénultième 323.

Le procédé de localisation est ainsi itéré en remontant, de contacteur en contacteur, le long de la ligne PLUS 30, si nécessaire jusqu'au premier contacteur 312.

Si le capteur 141 détecte encore l'existence d'un court-circuit, cela signifie que ce court-circuit ne peut être que le long du premier segment de ligne PLUS 31.

Ainsi, de proche en proche, en isolant les segments de la ligne de la source 51, il est possible de localiser la voiture dans laquelle survient le court-circuit.

De la même manière, en cas de détection d'un court-circuit entre la ligne MOINS 40 et la ligne de référence 20, l'actionnement séquentielle des contacteurs insérés dans la ligne MOINS 40 et le niveau du courant détecté par le circuit de mesure 110 permet de localiser le segment de ligne MOINS qui est en court-circuit avec la ligne de référence.

Bien évidement d'autre séquencement de l'ouverture des connecteurs peut être envisagée pour identifier le segment défectueux. Par exemple une approche par dichotomie est envisageable qui consiste à considérer d'abord le contacteur situé au milieu d'une ligne du circuit basse tension, puis, si le court-circuit est encore détectable, à considérer le contacteur situé au milieu de la moitié amont de la ligne et, dans le cas contraire, le contacteur situé au milieu de la moitié aval de la ligne. Le procédé est itéré en subdivisant chaque intervalle de la ligne de manière à converger vers le segment défectueux.

Pour vérifier le bon fonctionnement du circuit de mesure 110, périodiquement le troisième interrupteur 139 est fermé de manière à établir artificiellement un court-circuit entre la ligne PLUS 30 et la ligne de référence 20. On utilise alors les moyens de mesure du circuit de mesure 110 pour vérifier que ce dernier est capable de détecter ce court-circuit. Dans l'affirmative, le circuit de mesure 110 est considéré comme fonctionnel. A défaut, le circuit de mesure est considéré comme dysfonctionnel. Le signal d'alarme A peut permettre de remonter cette information.

De la même manière, le quatrième interrupteur 149 est fermé de manière à créer artificiellement un court-circuit entre la ligne MOINS 40 et la ligne de référence 20. On utilise ensuite les moyens de mesure du circuit de mesure 110 pour vérifier que l'on est capable de détecter le court-circuit ainsi créé. Dans l'affirmative, le circuit de mesure 110 est considéré comme fonctionnel. A défaut il est considéré comme dysfonctionnel. Le signal d'alarme A peut permettre de remonter cette information.

L'homme du métier constatera que le présent système permet la détection et la localisation aisées de n'importe quel type de court-circuit affectant un circuit électrique basse tension d'un véhicule ferroviaire.

## Revendications

1. Système de diagnostic (100) d'un état d'un circuit électrique basse tension continue (50) d'un véhicule ferroviaire (10), le véhicule ferroviaire (10) comportant une pluralité de voitures (11, 12, 13, 14) attelées les unes aux autres, le circuit électrique basse tension continue (50) comportant, circulant les unes parallèlement aux autres, le long de la pluralité voitures :
- une ligne de potentiel de référence (20), portée à un potentiel de référence ;
- une ligne de potentiel PLUS batterie (30), connectée à une borne positive d'une source de tension électrique (51) ; et,
- une ligne de potentiel MOINS batterie (40), connectée à une borne négative de la source de tension électrique (51),
le système de diagnostic (100) étant **caractérisé en ce que** la ligne de potentiel PLUS batterie (30) est constituée de la connexion en série d'une pluralité de segments de ligne de potentiel PLUS batterie (31, 32, 33, 34), la pluralité de segments de ligne de potentiel PLUS batterie comportant au moins un segment de ligne de potentiel PLUS batterie par voiture, deux segments de ligne de potentiel PLUS batterie successifs étant connectés par un contacteur de ligne de potentiel PLUS batterie (312, 323, 334) pouvant être commandé en position ouverte ou en position fermée, **en ce que** la ligne de potentiel MOINS batterie (40) est constituée de la connexion en série d'une pluralité de segments de ligne de potentiel MOINS batterie (41, 42, 43, 44), la pluralité de segments de ligne de potentiel MOINS batterie comportant au moins un segment de ligne de potentiel MOINS batterie par voiture, deux segments de ligne de potentiel MOINS batterie successifs étant connectés par un contacteur de ligne de potentiel MOINS batterie (412, 423, 434) pouvant être commandé en position ouverte ou en position fermée, le premier segment de ligne de potentiel PLUS batterie (31) étant connecté à la borne positive de la source de tension électrique (51) et le premier segment de ligne de potentiel MOINS batterie (41) étant connecté à la borne négative de la source de tension électrique (51),
et **en ce que** le système de diagnostic (100) comporte un moyen de commande (120) et un circuit de mesure (110), le circuit de mesure (110) comportant au moins une maille de mesure, ladite au moins une maille de mesure intégrant un moyen de mesure du courant circulant le long de ladite au moins une maille de mesure, un noeud d'extrémité de ladite au moins une maille de mesure étant relié électriquement à la ligne de potentiel de référence (20) et l'autre noeud d'extrémité de ladite au moins une maille de mesure pouvant être connecté, par un premier interrupteur commandé (130), au premier segment de ligne de potentiel PLUS batterie (31) et, par un second interrupteur commandé (140), au premier segment de ligne de potentiel MOINS batterie (41),
le moyen de commande (120) étant propre à basculer en fermeture le premier interrupteur (130) pour relier ladite au moins une maille de mesure à la ligne de potentiel PLUS batterie (30), et, en cas de détection d'un court-circuit, à basculer séquentiellement en ouverture les contacteurs de ligne de potentiel MOINS batterie pour localiser le court-circuit le long de la ligne de potentiel MOINS batterie (40),
et le moyen de commande (120) étant propre à basculer en fermeture le second interrupteur (140) pour relier ladite au moins une maille de mesure à la ligne de potentiel MOINS batterie (40), et, en cas de détection d'un court-circuit, à basculer séquentiellement en ouverture les contacteurs de ligne de potentiel PLUS batterie pour localiser le court-circuit le long de la ligne de potentiel PLUS batterie (30).

2. Système de diagnostic (100) selon la revendication 1, dans lequel le circuit de mesure (110) comporte :
- une première maille de mesure (135) intégrant le premier interrupteur commandé (130) et des premiers moyens de mesure du courant circulant dans la première maille de mesure (135) ; et,
- une seconde maille de mesure (145) intégrant le second interrupteur commandé (140) et des seconds moyens de mesure du courant circulant dans la seconde maille de mesure (145).

3. Système de diagnostic (100) selon la revendication 2, dans lequel les moyens de mesure du courant circulant dans la première maille de mesure, respectivement circulant dans la seconde maille de mesure, comportent une première résistance (132) le long de la première maille de mesure, respectivement une seconde résistance (142) le long de la première maille de mesure, et un premier capteur de courant (131) propre à mesure un courant circulant à travers la première résistance, respectivement un second capteur de courant (141) le long de la seconde maille de mesure, les premier et seconds capteurs de courant étant de préférence du type par induction.

4. Système de diagnostic (100) selon l'une quelconque des revendications 1 à 3, dans lequel le moyen de mesure du courant circulant le long de ladite au moins une maille est propre à transmettre une mesure d'intensité au moyen de commande (120), et le moyen de commande (120) est propre à comparer la mesure d'intensité reçue avec un seuil prédéterminé, un court-circuit étant détecté lorsque la mesure d'intensité reçue est supérieure au seuil prédéterminé.

5. Système de diagnostic (100) selon l'une quelconque des revendications 1 à 4, comportant en outre un circuit de test (114) d'un état de fonctionnement du circuit de mesure (110), le circuit de test étant commandé par le moyen de commande (120) pour créer un court-circuit artificiel le long du circuit électrique basse tension continue (50) de manière à pouvoir vérifier que le circuit de mesure (110) est capable de détecter ledit court-circuit artificiel.

6. Système de diagnostic (100) selon l'une quelconque des revendications 1 à 5, dans lequel le moyen de commande (120) est programmé pour que la séquence d'ouverture des contacteurs de la ligne de potentiel MOINS batterie, respectivement de la ligne de potentiel PLUS batterie, afin de localiser un court-circuit consiste à remonter la ligne de potentiel MOINS batterie, respectivement la ligne de potentiel PLUS batterie, depuis une extrémité aval, située à l'écart de la source de tension électrique (51), vers une extrémité amont, à proximité de la source de tension électrique (51), en ouvrant un contacteur courant et en déterminant si le circuit de mesure (110) détecte encore le court-circuit, dans l'affirmative, le moyen de commande (120) considère un contacteur suivant le contacteur courant et, dans la négative, le moyen de commande (120) considère que le court-circuit est localisé entre le contacteur courant et un contacteur précédent le contacteur courant.

7. Véhicule ferroviaire comportant un circuit électrique basse tension continue (50), le véhicule ferroviaire (10) comportant une pluralité de voitures (11, 12, 13, 14) attelées les unes aux autres, le circuit électrique basse tension continue (50) comportant, circulant les unes parallèlement aux autres, le long de la pluralité voitures :
- une ligne de potentiel de référence (20), portée à un potentiel de référence ;
- une ligne de potentiel PLUS batterie (30), connectée à une borne positive d'une source de tension électrique (51) ; et,
- une ligne de potentiel MOINS batterie (40), connectée à une borne négative de la source de tension électrique (51),
le véhicule ferroviaire étant **caractérisé en ce qu'**il comporte un système de diagnostic conforme à l'une quelconque des revendications 1 à 6.

8. Procédé de diagnostic d'un état d'un circuit électrique basse tension (50) d'un véhicule ferroviaire (10), le véhicule ferroviaire (10) comportant une pluralité de voitures (11, 12, 13, 14) attelées les unes aux autres, le circuit électrique basse tension continue (50) comportant, circulant les unes parallèlement aux autres, le long de la pluralité voitures :
- une ligne de potentiel de référence (20), portée à un potentiel de référence ;
- une ligne de potentiel PLUS batterie (30), connectée à une borne positive d'une source de tension électrique (51) ; et,
- une ligne de potentiel MOINS batterie (40), connectée à une borne négative de la source de tension électrique (51),
le procédé de diagnostic étant **caractérisé en ce qu'**il consiste, le véhicule ferroviaire étant équipé d'un système de diagnostic (110) selon l'une quelconque des revendications 1 à 6, à basculer en fermeture le premier interrupteur (130) pour relier la ligne de potentiel PLUS batterie à la ligne de référence via une première résistance 132 et, en cas de détection d'un court-circuit, à basculer séquentiellement en ouverture les contacteurs de ligne de potentiel MOINS batterie pour localiser le court-circuit le long de la ligne de potentiel MOINS batterie (40), et à basculer en fermeture le second interrupteur (140) pour relier la ligne de potentiel MOINS batterie (40) à la ligne de potentiel de référence via une seconde résistance (142), et, en cas de détection d'un court-circuit, à basculer séquentiellement en ouverture les contacteurs de ligne de potentiel PLUS batterie pour localiser le court-circuit le long de la ligne de potentiel PLUS batterie (30).

## Patentansprüche

1. System (100) zur Diagnose eines Zustands einer elektrischen Niederspannungs-Gleichstromschaltung (50) eines Schienenfahrzeugs (10), wobei das Schienenfahrzeug (10) eine Mehrzahl von Wagen (11, 12, 13, 14), die aneinander gekoppelt sind aufweist, wobei die elektrische Niederspannungs-Gleichstromschaltung (50) folgende, parallel zueinander entlang der Vielzahl von Wagen verlaufende Leitungen umfasst:
- eine Bezugspotentialleitung (20), die auf ein Bezugspotential gebracht wird;
- eine PLUS-Batterie-Potentialleitung (30), die mit einem Pluspol einer elektrischen Spannungsquelle (51) verbunden ist; und,
- eine MINUS-Batterie-Potentialleitung (40), die mit einem Minuspol der elektrischen Spannungsquelle (51) verbunden ist,
wobei das Diagnosesystem (100) **dadurch gekennzeichnet ist, dass** die PLUS-Batterie-Potentialleitung (30) durch die Reihenschaltung einer Vielzahl von PLUS-Batterie-Potentialleitungssegmenten (31, 32, 33, 34) gebildet wird, wobei die Vielzahl von PLUS-Batterie-Potentialleitungssegmenten mindestens ein PLUS-Batterie-Potentialleitungssegment pro Wagen umfasst, wobei zwei aufeinanderfolgende PLUS-Batterie-Potentialleitungssegmente durch einen PLUS-Batterie-Potentialleitungsschalter (312, 323, 334) verbunden sind, der in einer offenen oder geschlossenen Position gesteuert werden kann, wobei die MINUS-Batterie-Potentialleitung (40) durch die Reihenschaltung einer Vielzahl von MINUS-Batterie-Potentialleitungssegmenten (41, 42, 43, 44) entsteht, wobei die Vielzahl von MINUS-Batterie-Potentialleitungssegmenten mindestens ein MINUS-Batterie-Potentialleitungssegment pro Wagen umfasst, wobei zwei aufeinanderfolgende MINUS-Batterie-Potentialleitungssegmente durch einen MINUS-Batterie-Potentialleitungsschalter (412, 423, 434) verbunden sind, der in einer offenen oder geschlossenen Position gesteuert werden kann, wobei das erste PLUS-Batterie-Potentialleitungssegment (31) mit dem Pluspol der elektrischen Spannungsquelle (51) verbunden ist und das erste MINUS-Batterie-Potentialleitungssegment (41) mit dem Minuspol der elektrischen Spannungsquelle (51) verbunden ist,
und dass das Diagnosesystem (100) ein Steuermittel (120) und einen Messstromkreis (110) umfasst, wobei der Messstromkreis (110) mindestens eine Messmasche umfasst, wobei die mindestens eine Messmasche ein Mittel zur Messung des Stroms enthält, der entlang der mindestens einen Messmasche fließt, wobei ein Endknoten der mindestens einen Messmasche mit der Referenzpotentialleitung (20) elektrisch verbunden ist und der andere Endknoten der mindestens einen Messmasche über einen ersten gesteuerten Schalter (130) mit dem ersten Segment der PLUS-Batterie-Potentialleitung (31) und über einen zweiten gesteuerten Schalter (140) mit dem ersten Segment der MINUS-Batterie-Potentialleitung (41) verbunden werden kann,
wobei das Steuermittel (120) dazu geeignet ist, den ersten Schalter (130) zu schließen, um die mindestens eine Messmasche mit der PLUS-Batterie-Potentialleitung (30) zu verbinden, und bei Erkennung eines Kurzschlusses die MINUS-Batterie-Potentialleitungsschütze sequentiell zu öffnen, um den Kurzschluss entlang der MINUS-Batterie-Potentialleitung (40) zu lokalisieren,
und das Steuermittel (120) geeignet ist, den zweiten Schalter (140) zu schließen, um die mindestens eine Messmasche mit der MINUS-Batterie-Potentialleitung (40) zu verbinden, und bei Erkennung eines Kurzschlusses die PLUS-Batterie-Potentialleitungsschütze sequentiell zu öffnen, um den Kurzschluss entlang der PLUS-Batterie-Potentialleitung (30) zu lokalisieren.

2. System (100) nach Anspruch 1, wobei der Messstromkreis (110) Folgendes umfasst:
- eine erste Messmasche (135), die den ersten gesteuerten Schalter (130) und erste Mittel zur Messung des in der ersten Messmasche (135) fließenden Stroms beinhaltet; und
- eine zweite Messmasche (145), die den zweiten gesteuerten Schalter (140) und zweite Mittel zur Messung des in der zweiten Messmasche (145) fließenden Stroms beinhaltet.

3. Diagnosesystem (100) nach Anspruch 2, bei dem die Mittel zur Messung des in der ersten Messmasche fließenden Stroms bzw. des in der zweiten Messmasche fließenden Stroms einen ersten Widerstand (132) entlang der ersten Messmasche bzw. einen zweiten Widerstand (142) entlang der ersten Messmasche und einen ersten Stromsensor (131) enthalten, der geeignet ist, einen Strom zu messen, der durch den ersten Widerstand fließt, bzw. einen zweiten Stromsensor (141) entlang der zweiten Messmasche, wobei der erste und der zweite Stromsensor vorzugsweise Induktionssensoren sind.

4. Diagnosesystem (100) nach einem der Ansprüche 1 bis 3, wobei das Mittel zur Messung des Stroms, der entlang der mindestens einen Masche fließt, geeignet ist, eine Stromstärkenmessung an das Steuermittel (120) zu übertragen, und das Steuermittel (120) dazu geeignet ist, die erhaltene Stromstärkenmessung mit einem vorbestimmten Schwellenwert zu vergleichen, wobei ein Kurzschluss erkannt wird, wenn die erhaltene Stromstärkenmessung über dem vorbestimmten Schwellenwert liegt.

5. Diagnosesystem (100) nach einem der Ansprüche 1 bis 4, ferner mit einem Teststromkreis (114) zum Testen eines Betriebszustands des Messstromkreises (110), wobei der Teststromkreis durch das Steuermittel (120) gesteuert wird, um einen künstlichen Kurzschluss entlang des elektrischen Niederspannungs-Gleichstromkreises (50) zu erzeugen, so dass überprüft werden kann, ob der Messstromkreis (110) in der Lage ist, den künstlichen Kurzschluss zu erfassen.

6. Diagnosesystem (100) nach einem der Ansprüche 1 bis 5, bei dem das Steuermittel (120) so programmiert ist, dass die Sequenz des Öffnens der Schütze der MINUS-Batterie-Potentialleitung bzw. der PLUS-Batterie-Potentialleitung zur Lokalisierung eines Kurzschlusses darin besteht, die MINUS-Batterie-Potentialleitung bzw. die PLUS-Batterie-Potentialleitung von einem stromabwärts gelegenen Ende, das von der elektrischen Spannungsquelle (51) entfernt ist, zu einem stromaufwärtigen Ende in der Nähe der elektrischen Spannungsquelle (51) nach oben zu führen; indem ein Stromschütz geöffnet wird und festgestellt wird, ob der Messstromkreis (110) den Kurzschluss noch erkennt. Wenn ja, wählt das Steuermittel (120) einen dem aktuellen Schütz folgenden Schütz aus. Wenn dies nicht der Fall ist, geht das Steuermittel (120) davon aus, dass der Kurzschluss zwischen dem aktuellen Schütz und einem dem aktuellen Schütz vorangehenden Schütz lokalisiert ist.

7. Schienenfahrzeug mit einer elektrischen Niederspannungs-Gleichstromschaltung (50), wobei das Schienenfahrzeug (10) eine Vielzahl von aneinander gekoppelten Wagen (11, 12, 13, 14) aufweist, wobei die elektrische Niederspannungs-Gleichstromschaltung (50) folgende, parallel zueinander entlang der Vielzahl von Wagen verlaufende Leitungen umfasst:
- eine Bezugspotentialleitung (20), die auf ein Bezugspotential gebracht wird;
- eine PLUS-Batterie-Potentialleitung (30), die mit einem Pluspol einer elektrischen Spannungsquelle (51) verbunden ist; und,
- eine MINUS-Batterie-Potentialleitung (40), die mit einem Minuspol der elektrischen Spannungsquelle (51) verbunden ist,
das Schienenfahrzeug ist **dadurch gekennzeichnet ist, dass** es ein Diagnosesystem nach einem der Ansprüche 1 bis 6 umfasst.

8. Verfahren zur Diagnose eines Zustands eines Niederspannungsstromkreises (50) eines Schienenfahrzeugs (10), wobei das Schienenfahrzeug (10) eine Vielzahl von aneinander gekoppelten Wagen (11, 12, 13, 14) aufweist, wobei der elektrische Niederspannungs-Gleichstromkreis (50), parallel zueinander entlang der Vielzahl von Wagen zirkulierend, umfasst:
- eine Bezugspotentialleitung (20), die auf ein Bezugspotential gebracht wird;
- eine PLUS-Batterie-Potentialleitung (30), die mit einem Pluspol einer elektrischen Spannungsquelle (51) verbunden ist; und,
- eine MINUS-Batterie-Potentialleitung (40), die mit einem Minuspol der elektrischen Spannungsquelle (51) verbunden ist,
wobei das Diagnoseverfahren **dadurch gekennzeichnet ist, dass** es, wobei das Schienenfahrzeug mit einem Diagnosesystem (110) nach einem der Ansprüche 1 bis 6 ausgestattet ist, darin besteht den ersten Schalter (130) zu schließen, um die PLUS-Batterie-Potentialleitung über einen ersten Widerstand 132 mit der Referenzleitung zu verbinden, und bei Erkennung eines Kurzschlusses sequentiell die Schalter der MINUS-Batterie-Potentialleitung zu öffnen, um den Kurzschluss entlang der MINUS-Batterie-Potentialleitung (40) zu lokalisieren, und den zweiten Schalter (140) zu schließen, um die MINUS-Batterie-Potentialleitung (40) über einen zweiten Widerstand (142) mit der Referenzleitung zu verbinden, und, wenn ein Kurzschluss detektiert wird, sequentiell die Schalter der PLUS-Batterie-Potentialleitung zu öffnen, um den Kurzschluss entlang der PLUS-Batterie-Potentialleitung (30) zu lokalisieren.

## Claims

1. System (100) for diagnosing a state of a low-voltage DC electrical circuit (50) of a rail vehicle (10), the rail vehicle (10) comprising a plurality of carriages (11, 12, 13, 14) coupled to one another, the low-voltage DC electrical circuit (50) comprising, running parallel to one another, along the plurality of carriages :
- a reference potential line (20), raised to a reference potential;
- a POSITIVE battery potential line (30), connected to a positive terminal of an electrical voltage source (51); and,
- a NEGATIVE battery potential line (40), connected to a negative terminal of the electrical voltage source (51),
the diagnostic system (100) being **characterised in that** the line of potential POSITIVE battery (30) is composed of the serial connection of a plurality of line segments of potential POSITIVE battery (31, 32, 33, 34), the plurality of line segments POSITIVE battery with at least one line segment of potential POSITIVE battery per car, two line segments of potential POSITIVE battery being connected by line switch POSITIVE battery (312, 323, 334) that can be controlled in the open or closed position, **in that** the potential line NEGATIVE battery (40) consists of the serial connection of a plurality of potential line segments NEGATIVE battery (41, 42, 43, 44), the plurality of potential line segments NEGATIVE battery with at least one potential line segment NEGATIVE battery per car, with two potential line segments NEGATIVE battery connected by a potential line switch NEGATIVE battery (412, 423, 434) can be controlled in either open or closed position, with the first potential line segment POSITIVE battery (31) connected to the positive terminal of the electrical voltage source (51) and the first potential line segment NEGATIVE battery (41) connected to the negative terminal of the electrical voltage source (51),
and **in that** the diagnostic system (100) comprises control means (120) and a measurement circuit (110), the measurement circuit (110) comprising at least one measurement mesh, said at least one measurement mesh incorporating means for measuring the current flowing along said at least one measurement mesh, one end node of said at least one measurement mesh being electrically connected electrically to the reference potential line (20) and the other end node of said at least one measuring mesh being connectable, by a first controlled switch (130), to the first POSITIVE battery potential line segment (31) and, by a second controlled switch (140), to the first NEGATIVE battery potential line segment (41),
the control means (120) being suitable for switching the first switch (130) closed in order to connect the said at least one measuring mesh to the POSITIVE battery potential line (30), and, in the event of a short-circuit being detected, for sequentially switching the NEGATIVE battery potential line contactors open in order to locate the short-circuit along the NEGATIVE battery potential line (40),
and the control means (120) being suitable for switching the second switch (140) closed in order to connect the said at least one measuring mesh to the battery NEGATIVE potential line (40), and, in the event of a short-circuit being detected, for sequentially switching the battery POSITIVE potential line contactors open in order to locate the short-circuit along the battery POSITIVE potential line (30).

2. The compressed air circuit (100) according to claim 1, wherein the connection socket (110) comprises:
- a first measuring grid (135) incorporating the first controlled switch (130) and first means of measuring the current flowing in the first measuring grid (135); and,
- a second measuring mesh (145) incorporating the second controlled switch (140) and second means for measuring the current flowing in the second measuring mesh (145).

3. A diagnostic system (100) as claimed in claim 2, in which the means for measuring the current flowing in the first measuring mesh, respectively flowing in the second measuring mesh, comprise a first resistor (132) along the first measuring mesh, respectively a second resistor (142) along the first measuring mesh, and a first current sensor (131) suitable for measuring a current flowing through the first resistor, respectively a second current sensor (141) along the second measuring mesh, the first and second current sensors preferably being of the induction type.

4. A diagnostic system (100) according to any one of claims 1 to 3, wherein the means for measuring the current flowing along said at least one mesh is adapted to transmit a current measurement to the control means (120), and the control means (120) is adapted to compare the received current measurement with a predetermined threshold, a short-circuit being detected when the received current measurement is greater than the predetermined threshold.

5. A diagnostic system (100) according to any one of claims 1 to 4, further comprising a circuit (114) for testing an operating state of the measurement circuit (110), the test circuit being controlled by the control means (120) to create an artificial short circuit along the low-voltage DC electrical circuit (50) so as to be able to check that the measuring circuit (110) is capable of detecting said artificial short circuit.

6. Diagnostic system (100) according to any of the demands 1 to 5, in which the means of control (120) is programmed so that the switch opening sequence of the potential line NEGATIVE battery, respectively of the potential line POSITIVE battery, in order to locate a short circuit consists of reassembling the POSITIVE battery potential line, respectively, the POSITIVE battery potential line, from a downstream end, located away from the voltage source (51), to an upstream end, in the vicinity of the electrical voltage source (51), by opening a current switch and determining whether the measuring circuit (110) still detects the short circuit, if so, the means of control (120) considers a switch following the current switch and, if not, the means of control (120) considers that the short circuit is located between the current switch and a switch preceding the current switch.

7. Rail vehicle comprising a low-voltage DC electrical circuit (50), the rail vehicle (10) comprising a plurality of carriages (11, 12, 13, 14) coupled to one another, the low-voltage DC electrical circuit (50) comprising, running parallel to one another along the plurality of carriages :
- a reference potential line (20), raised to a reference potential;
- a POSITIVE battery potential line (30), connected to a positive terminal of an electrical voltage source (51); and,
- a battery NEGATIVE potential line (40), connected to a negative terminal of the electrical voltage source (51),
the railway vehicle, **characterised in that** it comprises a diagnostic system in accordance with any of claims 1 to 6.

8. Method for diagnosing a state of a low-voltage electrical circuit (50) of a rail vehicle (10), the rail vehicle (10) comprising a plurality of carriages (11, 12, 13, 14) coupled to one another, the low-voltage DC electrical circuit (50) comprising, running parallel to one another, along the plurality of carriages:
- a reference potential line (20), raised to a reference potential;
- a POSITIVE battery potential line (30), connected to a positive terminal of an electrical voltage source (51); and,
- a battery NEGATIVE potential line (40), connected to a negative terminal of the electrical voltage source (51),
the diagnostic method being **characterised in that** it consists, the rail vehicle being equipped with a diagnostic system (110) according to any one of claims 1 to 6, in toggling the first switch (130) closed in order to connect the battery POSITIVE potential line to the reference line via a first resistor 132 and, if a short-circuit is detected, toggling the line switches to locate the short-circuit along the battery NEGATIVE potential line (40), and switching the second switch (140) to ON to connect the battery NEGATIVE potential line (40) to the reference potential line via a second resistor (142), and, if a short-circuit is detected, sequentially switching open the battery POSITIVE potential line switches to locate the short-circuit along the battery POSITIVE potential line (30).
